# EUROPEAN PATENT APPLICATION

(11) **EP 4 495 995 A1**
(43) Date of publication of application: **22.01.2025**
(21) Application number: 23887166.9
(22) Date of filing: 27.09.2023
(51) Int. Cl.: H01L 23/498, H01L 21/48, H01L 21/60, G01N 27/00

(54) **INTEGRATED CIRCUIT PACKAGING STRUCTURE, PACKAGING METHOD, AND DIE PROPERTY COMPARISON SYSTEM**

(30) Priority: 09.06.2023 CN 202310685613
(71) Applicant: Haiguang Integrated Circuit Design (Beijing) Co., Ltd., Beijing 100193 (CN)
(72) Inventor: YU, Cong, Haidian District, Beijing 100193 (CN)
(74) Representative: Regimbeau
(86) International application number: PCT/CN2023/122138
(87) International publication number: WO 2024/250500

(57) **Abstract**

The embodiments of the present disclosure provide an integrated circuit package structure, an integrated circuit packaging method and a die performance comparison system, the integrated circuit package structure includes: a substrate; at least two redistribution layers, wherein the at least two redistribution layers are stacked on the substrate, and a metal connection line of a redistribution layer adjacent to the substrate is connected with a metal connection line of the substrate, and metal connection lines of two adjacent redistribution layers are connected to each other; a die, wherein the die is disposed on a top redistribution layer, and the die is connected with a metal connection line of the top redistribution layer. The embodiments of the present disclosure can reduce the manufacturing cost of the substrate and facilitate realizing reuse of the substrate.

## Description

### CROSS-REFERENCE TO RELATED APPLICATION

This disclosure claims the priority of China patent application No.202310685613.2 filed on June 9, 2023, and the contents of the above-mentioned China patent application are hereby incorporated in its entirety as a part of this disclosure.

### TECHNICAL FIELD

The embodiments of the disclosure relate to an integrated circuit package structure, an integrated circuit packaging method and a die performance comparison system.

### BACKGROUND

With the increase of the number of layers and area of a substrate, the yield is decreased significantly, while the production cycle is significantly prolonged. How to effectively control the cost of substrate and increase the supply chain capacity is under constant pressure currently.

Due to requirements for extremely high computing power and data throughput, more input and output (IO) ports are introduced in product design and packaging for a chip, which leads to a significant increase in the number of layers of the substrate, which further leads to a higher manufacturing cost of the substrate.

Forming a redistribution layer (RDL) on a surface of the die to reduce the number of substrate layers can reduce the manufacturing cost of the substrate. However, the effect of RDL with two to four circuit layers on reducing the number of substrate layers is effective.

In addition, the improvement of chip performance and the number of integrated circuits being increasing will be realized by means of chip process upgrading, architectural updating and advanced packaging, which results in that the chip update iteration cycle is accelerated, and due to update on process, architecture, etc., in products between the generations, a substrate cannot be reused for different chips, and the product iteration cost is also increased.

### SUMMARY

The embodiments of the disclosure provide an integrated circuit package structure, an integrated circuit packaging method and a die performance comparison system, which can reduce the manufacturing cost of substrate and facilitate reuse of the substrate.

In a first aspect, the embodiments of the present disclosure provides an integrated circuit package structure, including: a substrate; at least two redistribution layers, wherein the at least two redistribution layers are stacked on the substrate, and a metal connection line of a redistribution layer adjacent to the substrate is connected with a metal connection line of the substrate, and metal connection lines of two adjacent redistribution layers are connected to each other; a die, wherein the die is disposed on a top redistribution layer, and the die is connected with a metal connection line of the top redistribution layer.

According to a specific implementation of the embodiments of the present disclosure, the at least two redistribution layers comprise a first redistribution layer and a second redistribution layer; the first redistribution layer is disposed on the substrate, and a metal connection line of the first redistribution layer is connected with the metal connection line of the substrate; the second redistribution layer is disposed on the first redistribution layer, and a metal connection line of the second redistribution layer is connected with the metal connection line of the first redistribution layer.

According to a specific implementation of the embodiments of the present disclosure, the first redistribution layer is provided with a first connection bump, and the first connection bump is connected with the metal connection line of the first redistribution layer, and the metal connection line of the first redistribution layer is connected with the metal connection line of the substrate through the first connection bump; and/or the second redistribution layer is provided with a second connection bump, and the second connection bump is connected with the metal connection line of the second redistribution layer, and the metal connection line of the second redistribution layer is connected with the metal connection line of the first redistribution layer through the second connection bump.

According to a specific implementation of the embodiments of the present disclosure, the first redistribution layer is provided with a first connection part, and the first connection part is connected with the metal connection line of the first redistribution layer and bonded to a corresponding connection part of the substrate; the corresponding connection part of the substrate is connected with the metal connection line of the substrate; and/or the second redistribution layer is provided with a second connection part, the second connection part is connected with the metal connection line of the second redistribution layer, and the second connection part is bonded to a corresponding connection part of the first redistribution layer, and the corresponding connection part of the first redistribution layer is connected with the metal connection line of the first redistribution layer.

According to a specific implementation of the embodiments of the present disclosure, the integrated circuit package structure further includes: a capacitor, wherein the capacitor and the die are both disposed on the top redistribution layer; or, the capacitor is disposed on the substrate.

In a second aspect, the embodiments of the present disclosure provide an integrated circuit packaging method, including: disposing at least two redistribution layers stacked on a surface of a substrate, and connecting a metal connection line of a redistribution layer adjacent to the substrate with a metal connection line of the substrate, and connecting metal connection lines of two adjacent redistribution layers to each other; disposing a die on a top redistribution layer, and connecting the die with a metal connection line of the top redistribution layer; or, disposing a die with a redistribution layer on the top redistribution layer, and connecting a metal lead of the redistribution layer of the die with the metal connection line of the top redistribution layer.

According to a specific implementation of the embodiments of the present disclosure, the disposing the at least two redistribution layers stacked on the surface of the substrate comprises: disposing a first redistribution assembly on the surface of the substrate, wherein the first redistribution assembly comprises a first temporary carrier and a first redistribution layer disposed on and connected to the first temporary carrier; connecting a metal connection line of the first redistribution layer with the metal connection line of the substrate; separating the first temporary carrier from the first redistribution layer; disposing a second redistribution assembly on the first redistribution layer, wherein the second redistribution assembly comprises a second temporary carrier and a second redistribution layer disposed on and connected to the second temporary carrier; connecting a metal connection line of the second redistribution layer with the metal connection line of the first redistribution layer; separating the second temporary carrier from the second redistribution layer.

According to a specific implementation of the embodiments of the present disclosure, before the disposing the first redistribution assembly on the surface of the substrate, the integrated circuit packaging method further comprises: prefabricating redistribution assemblies; wherein the prefabricating the redistribution assemblies comprises: temporarily connecting two or more temporary carriers to a same one initial carrier; temporarily generating redistribution layers on the two or more temporary carriers; separating the two or more temporary carriers from the initial carrier to obtain at least two redistribution assemblies.

According to a specific implementation of the embodiments of the present disclosure, the temporarily connecting the two or more temporary carriers to the same one initial carrier comprises: temporarily bonding the two or more temporary carriers to the same one initial carrier through a temporary bonding adhesive.

According to a specific implementation of the embodiments of the present disclosure, the temporarily generating the redistribution layers on the two or more temporary carriers comprises: disposing temporary bonding adhesives on the two or more temporary carriers; generating the redistribution layers on the temporary bonding adhesives.

According to a specific implementation of the embodiments of the present disclosure, before the separating the two or more temporary carriers from the initial carrier, the integrated circuit packaging method further comprises: disposing connection bumps on surfaces of the redistribution layers that are temporarily generated away from the temporary carriers, wherein the connection bumps are respectively connected with metal connection lines of the redistribution layers that are temporarily generated.

In a third aspect, the embodiments of the present disclosure provides an integrated circuit packaging method, comprising: disposing at least two redistribution layers stacked on a first substrate, and connecting a metal connection line of a redistribution layer adjacent to the first substrate with a metal connection line of the first substrate, and connecting metal connection lines of two adjacent redistribution layers to each other; disposing a first die on a top redistribution layer over the first substrate, and connecting the first die with a metal connection line of the top redistribution layer over a surface of the first substrate, so as to obtain a first integrated circuit package structure; disposing at least two redistribution layers stacked on a second substrate, and connecting a metal connection line of a redistribution layer adjacent to the second substrate with a metal connection line of the second substrate, and connecting metal connection lines of two adjacent redistribution layers to each other; disposing a second die on a top redistribution layer over the second substrate, and connecting the second die with a metal connection line of the top redistribution layer over a surface of the second substrate, so as to obtain a second integrated circuit package structure; wherein the second substrate and the first substrate are a same substrate; the redistribution layers on the first substrate and the redistribution layers on the second substrate are different redistribution layers, and/or the second die and the first die are different dies.

According to a specific implementation of the embodiments of the present disclosure, the disposing the at least two redistribution layers stacked on the first substrate comprises: disposing a first redistribution assembly on the surface of the first substrate, wherein the first redistribution assembly comprises a first temporary carrier and a first redistribution layer disposed on and connected to the first temporary carrier; connecting a metal connection line of the first redistribution layer with the metal connection line of the first substrate; separating the first temporary carrier from the first redistribution layer; disposing a second redistribution assembly on the first redistribution layer, wherein the second redistribution assembly comprises a second temporary carrier and a second redistribution layer disposed on and connected to the second temporary carrier; connecting a metal connection line of the second redistribution layer with the metal connection line of the first redistribution layer; separating the second temporary carrier from the second redistribution layer.

According to a specific implementation of the embodiments of the present disclosure, the disposing at least two redistribution layers stacked on the second substrate comprises: disposing a third redistribution assembly on the surface of the second substrate, wherein the third redistribution assembly comprises a third temporary carrier and a third redistribution layer disposed on and connected to the third temporary carrier; connecting a metal connection line of the third redistribution layer with the metal connection line of the second substrate; separating the third temporary carrier from the third redistribution layer; disposing a fourth redistribution assembly on the third redistribution layer, wherein the fourth redistribution assembly comprises a fourth temporary carrier and a fourth redistribution layer disposed on and connected to the fourth temporary carrier; connecting a metal connection line of the fourth redistribution layer with the metal connection line of the third redistribution layer; separating the fourth temporary carrier from the fourth redistribution layer.

According to a specific implementation of the embodiments of the present disclosure, before the disposing the first redistribution assembly on the surface of the first substrate, the integrated circuit packaging method further comprises: prefabricating redistribution assemblies; wherein the prefabricating the redistribution assemblies comprises: temporarily connecting two or more temporary carriers to a same one initial carrier; temporarily generating redistribution layers on the two or more temporary carriers; separating the two or more temporary carriers from the initial carrier, so as to obtain at least two redistribution assemblies.

According to a specific implementation of the embodiments of the present disclosure, the temporarily connecting the two or more temporary carriers to the same one initial carrier comprises: temporarily bonding the two or more temporary carriers to the same one initial carrier through a temporary bonding adhesive.

According to a specific implementation of the embodiments of the present disclosure, the temporarily generating the redistribution layers on the two or more temporary carriers comprises: disposing temporary bonding adhesives on the two or more temporary carriers; generating the redistribution layers on the temporary bonding adhesives.

According to a specific implementation of the embodiments of the present disclosure, before the separating the two or more temporary carriers from the initial carrier, the integrated circuit packaging method further comprises: disposing connection bumps on surfaces of the redistribution layers that are temporarily generated away from the temporary carriers, wherein the connection bumps are respectively connected with metal connection lines of the redistribution layers that are temporarily generated.

In a fourth aspect, the embodiments of the present disclosure provides a die performance comparison system, comprising: a first integrated circuit package structure, wherein the first integrated circuit package structure comprises a first substrate, at least two redistribution layers stacked on the first substrate, and a first die disposed on a top redistribution layer; a second integrated circuit package structure, wherein the second integrated circuit package structure comprises a second substrate, at least two redistribution layers stacked on the second substrate, and a second die disposed on a top redistribution layer; wherein the second substrate and the first substrate are a same substrate; the redistribution layers on the first substrate and the redistribution layers on the second substrate are different redistribution layers, and/or the second die and the first die are different dies; and a die performance testing device, configured to perform a performance test on the first die in the first integrated circuit package structure and the second die in the second integrated circuit package structure, respectively, so that a data analysis apparatus compares performance of the first die and the second die according to data obtained from the performance test.

In the integrated circuit package structure, an integrated circuit packaging method and a die performance comparison system of the embodiments of the present disclosure, at least two layers of metal connection lines are disposed in the substrate, and metal connection lines of the layers are connected to each other by vias, at least two redistribution layers are stacked on the substrate, a metal connection line of a redistribution layer adjacent to the substrate is connected to a metal connection line of the substrate, and metal connection lines of two adjacent redistribution layers are connected to each other, a die is disposed on a top redistribution layer, and the die is connected to the metal connection line of the top redistribution layer. Since at least two redistribution layers are stacked on the substrate, the positions of metal connection lines wiring from the redistribution layer to the substrate can be designed more flexibly in the at least two RDLs, so that the number of layers of the metal connection lines in the substrate can be reduced, thereby reducing the manufacturing cost of the substrate. In addition, the existing connection positions on the substrate for connecting to the redistribution layer can be combined with the flexible design of the number of redistribution layers, such that the positions of the metal connection lines led out from the redistribution layers to the substrate correspond to the metal connection lines of the substrate. In this way, reuse of the substrate can be realized.

### BRIEF DESCRIPTION OF DRAWINGS

In order to explain the technical scheme of the embodiments of the present disclosure more clearly, the drawings required in the embodiments will be briefly introduced below. Obviously, the drawings described below are only some embodiments of the present disclosure, and other drawings can be obtained according to these drawings without creative work for a person ordinarily skilled in the art.
FIG. 1 is a schematic structural view of an integrated circuit package structure provided by an embodiment of the present disclosure;
FIG. 2 illustrates a schematic flowchart of an integrated circuit packaging method provided by an embodiment of the present disclosure;
FIG. 3 illustrates a schematic flowchart of an integrated circuit packaging method provided by yet another embodiment of the present disclosure;
FIG. 4 is a schematic view illustrating a process flow of an integrated circuit packaging method provided by an embodiment of the present disclosure;
FIG. 5 illustrates a front view of FIG. 4;
FIG. 6 illustrates a schematic structural view according to an alternative embodiment of FIG. 4;
FIG. 7 to FIG. 13 are schematic views illustrating a process flow of an integrated circuit packaging method according to a specific embodiment of the present disclosure.

### DETAILED DESCRIPTION

The embodiments of the present disclosure will be described in detail below with reference to the accompany drawings. It should be clear that the described embodiments are only a part of the embodiments of the present disclosure, but are not all of the embodiments. Based on the embodiments in the disclosure, all other embodiments obtained by people ordinarily skilled in the art without creative work belong to the scope of protection of the disclosure.

In order to make people skilled in the art better understand the technical concept, implementation and beneficial effects of the embodiments of the present disclosure, the following is a detailed description through specific embodiments.

An embodiment of the present disclosure provides an integrated circuit package structure, which can reduce the manufacturing cost of a substrate and facilitate the reuse of the substrate.

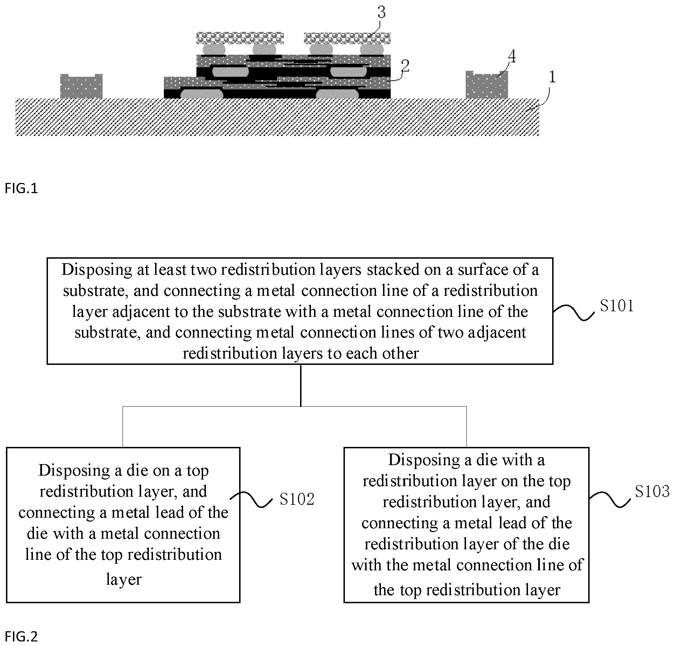

FIG. 1 is a schematic structural view of an integrated circuit package structure provided by an embodiment of the present disclosure. As shown in FIG. 1, the integrated circuit package structure of this embodiment may include:

A substrate 1, which is provided with two or more layers of metal connection lines, and the metal connection lines between layers are connected through vias.

The substrate 1 has functions in following three aspects: conductivity, insulation and support. The two or more layers of metal connection lines can play the role of electrical extension, that is, a die 3 is led out through the metal connection lines of the substrate 1.

The cost of a chip using the substrate 1 largely depends on the manufacturing cost of the substrate 1, while the manufacturing cost of the substrate 1 largely depends on the number of the layers of the substrate 1.

At least two redistribution layers 2, wherein the at least two redistribution layers 2 are stacked on the substrate 1, and a metal connection line of a redistribution layer adjacent to the substrate 1 is connected with a metal connection line of the substrate 1, and metal connection lines of two adjacent redistribution layers 2 are connected to each other.

The redistribution layer (RDL) plays the role of electrical extension and interconnection in the XY plane.

RDL can change the line pad position of the chip from the originally designed line pad (I/O pad) position of the die 3 through wafer-level metal wiring and bumping process, so that the chip can be applied to different package forms.

At present, the manufacturing capacity of the redistribution layer is limited, and only a limited number of circuit layers, such as two to four layers, can be manufactured in one redistribution layer, and more circuit layers cannot be manufactured in one redistribution layer, in this embodiment, through stacking at least two redistribution layers 2 on the substrate 1, connecting a metal connection line of a redistribution layer adjacent to the substrate 1 to a metal connection line of the substrate 1, and connecting metal connection lines of two adjacent redistribution layers 2 to each other, the positions of metal connection lines wiring from the redistribution layer to the substrate 1 can be designed more flexibly in the at least two RDLs, so that the number of layers of the metal connection lines in the substrate 1 can be reduced. In addition, the existing connection positions on the substrate 1 for connecting to the redistribution layer can be combined with the flexible design of the number of redistribution layers, such that the positions of the metal connection lines led out from the redistribution layers to the substrate 1 correspond to the substrate 1. In this way, reuse of the substrate 1 is realized, that is to say, different dies 3 can use the same one substrate 1 through the setting of different RDLs, respectively, and different dies 3 using different substrates 1 can be avoided.

In this embodiment, the interconnection between the metal connection line of the redistribution layer adjacent to the substrate 1 and the metal connection line of the substrate 1may be direct connection or indirect connection through solder bump(s) and/or copper pillar bump(s).

In this embodiment, the interconnection between the metal connection lines of two adjacent redistribution layers 2 may be direct connection or indirect connection through solder bump(s) and/or copper pillar bump(s).

A die 3, wherein the die 3 is disposed on a top redistribution layer, and the die 3 is connected with a metal connection line of the top redistribution layer.

The die 3 is connected with a metal connection line of the top redistribution layer, metal connection lines of two adjacent redistribution layers 2 are connected to each other, and a metal connection line of a redistribution layer adjacent to the substrate 1 is connected with a metal connection line of the substrate 1, so that the die 3 can be connected to the substrate 1 through the redistribution layers, wherein the die 3 is a function die.

It can be understood that, when the number of the die(s) 3 is two or more, the top redistribution layer in this embodiment can further realize the interconnection between the dies 3.

In this embodiment, the at least two redistribution layers 2 are stacked on the substrate 1, and a metal connection line of a redistribution layer adjacent to the substrate 1 is connected with a metal connection line of the substrate 1, and metal connection lines of two adjacent redistribution layers 2 are connected to each other, and the die 3 is disposed on a top redistribution layer, and the die 3 is connected with a metal connection line of the top redistribution layer. Since at least two redistribution layers 2 are stacked on the substrate 1, it is possible to more flexibly design, among the at least two RDLs, the positions of the metal connection lines leading out of the redistribution layers to the substrate 1, so that the number of layers of the metal connection lines in the substrate 1 can be reduced, and furthermore, the existing connection positions on the substrate 1 for connecting to the redistribution layer can be combined with the flexible design of the number of redistribution layers, so that the positions of the metal connection lines leading out of the redistribution layers to the substrate 1 correspond to the metal connection lines of the substrate 1. In this way, reuse of the substrate 1 is realized, that is to say, different dies 3 can use the same one substrate 1 through the setting of the number of different RDLs, respectively, thereby avoiding the use of different substrates 1 for different dies 3.

In some embodiments, the at least two redistribution layers 2 include a first redistribution layer and a second redistribution layer, the first redistribution layer is disposed on the substrate 1, and a metal connection line of the first redistribution layer is connected with the metal connection line of the substrate 1; the second redistribution layer is disposed on the first redistribution layer, and a metal connection line of the second redistribution layer is connected with the metal connection line of the first redistribution layer.

In the case where two redistribution layers of the at least two redistribution layers 2 are the first redistribution layer and the second redistribution layer, the metal connection line of the first redistribution layer is connected with the metal connection line of the substrate 1, the second redistribution layer is disposed on the first redistribution layer; and the metal connection line of the second redistribution layer is connected with the metal connection line of the first redistribution layer.

The metal connection line of the first redistribution layer is connected with the metal connection line of the substrate 1, and the metal connection line of the second redistribution layer is connected with the metal connection line of the first redistribution layer. In order to make the connection more reliable and stable, the metal connection line of the first redistribution layer may be indirectly connected with the substrate 1. In some embodiments, the first redistribution layer is provided with first connection bump(s); the first connection bump(s) is/are connected with the metal connection line of the first redistribution layer; and the metal connection line of the first redistribution layer is connected with the metal connection line of the substrate 1 through the first connection bump(s).

The first connection bump(s) may be copper pillar bump(s) and/or solder bump(s).

In this embodiment, in order to improve the reliability of the package structure, underfill may be performed between the substrate 1 and the first redistribution layer.

In yet other embodiments, the second redistribution layer is provided with second connection bump(s); the second connection bump(s) is/are connected with the metal connection line of the second redistribution layer, and the metal connection line of the second redistribution layer is connected with the metal connection line of the first redistribution layer through the second connection bump(s).

The second connection bump(s) may be copper pillar bump(s) and/or solder bump(s).

In this embodiment, in order to improve the reliability of the package structure, underfill may be performed between the first redistribution layer and the second redistribution layer.

In order to shorten the signal transmission path, in some embodiments, the first redistribution layer is provided with a first connection part, and the first connection part is connected with the metal connection line of the first redistribution layer and bonded to a corresponding connection part of the substrate 1; the corresponding connection part of the substrate 1 is connected with the metal connection line of the substrate 1.

The first connection part may be pad(s), and the pad(s) is/are disposed on via(s) in the first redistribution layer and configured to be bonded to the corresponding connection part of the substrate 1. It can be understood that, the corresponding connection part on the substrate 1 may also be pad(s).

In this embodiment, the first redistribution layer is provided with the first connection part, and the first connection part is connected with the metal connection line of the first redistribution layer and bonded to the corresponding connection part of the substrate 1; the corresponding connection part of the substrate 1 is connected with the metal connection line of the substrate 1. In this way, the interconnection method between the first redistribution layer and the substrate 1 can reduce the interconnection path, thereby reducing the signal transmission path and improving the signal transmission quality.

In order to shorten the signal transmission path, in some embodiments, the second redistribution layer is provided with a second connection part, and the second connection part is connected with the metal connection line of the second redistribution layer, and the second connection part is bonded to a corresponding connection part of the first redistribution layer; the corresponding connection part of the first redistribution layer is connected with the metal connection line of the first redistribution layer.

The second connection part may be pad(s), and the pad(s) is/are disposed on via(s) in the second redistribution layer and configured to be bonded to the corresponding connection part of the first redistribution layer. It can be understood that the corresponding connection part of the first redistribution layer may also be pad(s).

In this embodiment, the second redistribution layer is provided with the second connection part, the second connection part is connected with the metal connection line of the second redistribution layer, and the second connection part is bonded to the corresponding connection part of the first redistribution layer, and the corresponding connection part of the first redistribution layer is connected with the metal connection line of the first redistribution layer. In this way, the interconnection method between the second redistribution layer and the first redistribution layer can reduce the interconnection path, thereby reducing the signal transmission path and improving the signal transmission quality.

In some embodiments, the integrated circuit package structure may further include a capacitor 4, wherein the capacitor 4 and the die 3 are both disposed on the top redistribution layer.

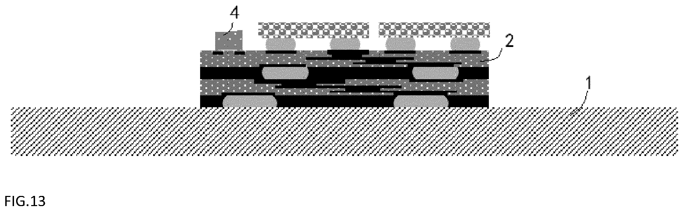

Referring to FIG. 13, the capacitor 4 is disposed on the top redistribution layer 2, so that the lead out position of pins of the capacitor 4 can also be extended through the at least two redistribution layers 2, thereby reducing the number of layers of the substrate 1 and facilitating the reuse of the substrate 1.

In yet other embodiments, referring to FIG. 1, the integrated circuit package structure may further include a capacitor 4, and the capacitor 4 is disposed on the substrate 1.

The integrated circuit packaging method provided by an embodiment of the present disclosure can reduce the manufacturing cost of the substrate and facilitate the reuse of the substrate.

FIG. 2 is a flowchart of an integrated circuit packaging method provided by an embodiment of the present disclosure. As shown in FIG. 1 and FIG. 2, the integrated circuit packaging method of this embodiment may include the following steps:
S101, disposing at least two redistribution layers stacked on a surface of a substrate, and connecting a metal connection line of a redistribution layer adjacent to the substrate with a metal connection line of the substrate, and connecting metal connection lines of two adjacent redistribution layers to each other.

The at least two redistribution layers 2 are stacked on the surface of the substrate 1, that is, the at least two redistribution layers 2 are sequentially disposed on the substrate 1 in a direction perpendicular to the substrate 1.

S102, disposing a die on a top redistribution layer, and connecting the die with a metal connection line of the top redistribution layer.

In this embodiment, at least two redistribution layers 2 are disposed and stacked on the surface of the substrate 1, such that the metal connection line of the redistribution layer adjacent to the substrate 1 is connected with the metal connection line of the substrate 1, and metal connection lines of two adjacent redistribution layers 2 are connected to each other; a die 3 is disposed on the top redistribution layer, such that the die 3 is connected with the metal connection line of the top redistribution layer. Because at least two redistribution layers 2 are stacked on the substrate 1, in this way, it is possible to more flexibly design the positions of the metal connection lines leading out from the redistribution layers to the substrate 1 in the at least two RDLs, and the number of layers of the metal connection lines in the substrate 1 can be reduced. In addition, it is possible to combine the connection positions of the substrate 1 for connecting to the redistribution layer, and by flexibly designing the number of redistribution layers, making the positions of the metal connection lines leading out from the redistribution layers to the substrate 1 correspond to the metal connection line of the substrate 1. In this way, the reuse of the substrate 1 can be realized. That is to say, different dies 3 can respectively use the same one substrate 1 by the setting of numbers of different RDLs, thereby avoiding the use of different substrates 1 for different dies 3.

As an alternative to S102, S102 can be replaced by S103, which is described specifically below.

S103, disposing a die 3 with a redistribution layer on the top redistribution layer, and connecting a metal lead of the redistribution layer of the die 3 with the metal connection line of the top redistribution layer.

In this embodiment, a redistribution layer is formed on the surface of the die 3, and the die 3 with the redistribution layer is disposed on the top redistribution layer, specifically, the metal lead of the redistribution layer of the die 3 is connected with the metal connection line of the top redistribution layer.

In order to dispose the at least two redistribution layers 2 on the surface of the substrate 1 more conveniently, in some embodiments, disposing at least two redistribution layers 2 stacked on the surface of the substrate 1 may include the following steps:
S101a, disposing a first redistribution assembly on the surface of the substrate.

The first redistribution assembly may include a first temporary carrier and a first redistribution layer disposed on and connected to the first temporary carrier.

In this embodiment, the first redistribution assembly may be formed by fabricating a first redistribution layer on the first temporary carrier, wherein the first redistribution layer includes one or more circuit layers.

S101b, connecting a metal connection line of the first redistribution layer with the metal connection line of the substrate.

S101c, separating the first temporary carrier from the first redistribution layer.

S101d, disposing a second redistribution assembly on the first redistribution layer.

In this embodiment, the second redistribution assembly may include a second temporary carrier and a second redistribution layer disposed on and connected to the second temporary carrier.

In this embodiment, the second redistribution assembly may be formed by fabricating the second redistribution layer on the second temporary carrier, wherein the second redistribution layer includes one or more circuit layers.

S101e, connecting a metal connection line of the second redistribution layer with the metal connection line of the first redistribution layer.

S101f, separating the second temporary carrier from the second redistribution layer.

In order to improve the production efficiency of multiple redistribution assemblies, in some embodiments, before the disposing the first redistribution assembly on the surface of the substrate, the integrated circuit packaging method further includes the following steps:
S104, prefabricating redistribution assemblies.

Wherein the prefabricating the redistribution assemblies (S 104) may include the following steps:
S104a, temporarily connecting two or more temporary carriers to a same one initial carrier.

In this embodiment, the temporary carrier may be a redistribution die, so that the redistribution die may not only be used as a carrier, but can also continue to be used as a functional die subsequently.

The initial carrier may be a redistribution wafer or a panel level carrier.

In some embodiments, the temporarily connecting the two or more temporary carriers to the same one initial carrier (S104a) may include:

A1, temporarily bonding the two or more temporary carriers to the same one initial carrier through a temporary bonding adhesive.

Through the temporary bonding adhesive, the two or more temporary carriers are temporarily bonded to the same one initial carrier.

S104b, temporarily generating redistribution layers on the two or more temporary carriers.

Temporarily generating the redistribution layers may be generating the redistribution layers on the temporary carriers, and the temporary carriers need to be separated from the redistribution layers subsequently.

In some embodiments, the temporarily generating the redistribution layers on the two or more temporary carriers (S104b) may include:
B1, disposing temporary bonding adhesives on the two or more temporary carriers.
B2, generating the redistribution layers on the temporary bonding adhesives.

The redistribution layers are generated on the temporary bonding adhesives, therefore, the temporary carriers can be more conveniently separated from the redistribution layers by debonding in a subsequent step.

S104c, separating the two or more temporary carriers from the initial carrier to obtain at least two redistribution assemblies.

At least two redistribution assemblies can be obtained by separating the more than two temporary carriers from the initial carrier through a debonding process.

In this embodiment, two or more temporary carriers are temporarily connected to the same one initial carrier, and redistribution layers are temporarily generated on the two or more temporary carriers, finally, the two or more temporary carriers are separated from the initial carrier to obtain at least two redistribution assemblies. In this way, two or more temporary carriers can be disposed on the initial carrier, and the redistribution layer is temporarily generated on each temporary carrier, in this way, a plurality of redistribution assemblies can be generated on one initial carrier, and the production efficiency of the redistribution assemblies can be improved.

In some embodiments, before separating the two or more temporary carriers from the initial carrier, the integrated circuit packaging method may further include:
C1, disposing connection bumps on surfaces of the temporarily generated redistribution layers away from the temporary carriers; wherein the connection bumps are respectively connected with metal connection lines of the temporarily generated redistribution layers.

The connection bumps may be solder bumps and/or copper pillar bumps.

The integrated circuit packaging method in the above embodiment can be used to implement the integrated circuit package structure in the above embodiment, and the implementation principle and technical effect thereof are similar. The features of the integrated circuit packaging method in this embodiment can be specifically referred to the above embodiment, and will not be repeated herein.

The integrated circuit packaging method provided by an embodiment of the present disclosure can reduce the manufacturing cost of the substrate and facilitate the reuse of the substrate.

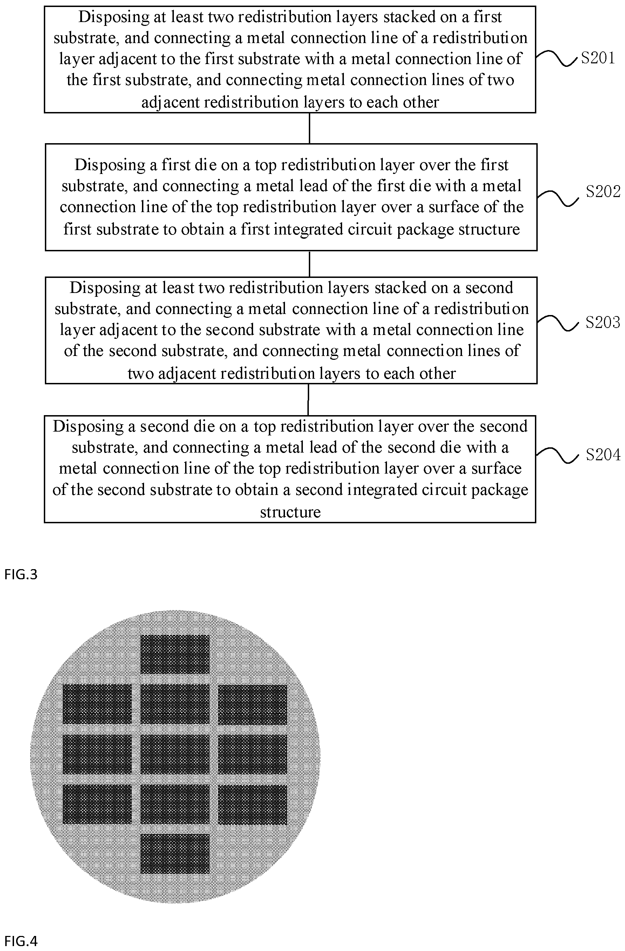

FIG. 3 is a schematic flow chart illustrating an integrated circuit packaging method provided by an embodiment of the present disclosure. As shown in FIG. 1 and FIG. 3, the integrated circuit packaging method of this embodiment may include the following steps:

S201, disposing at least two redistribution layers stacked on a first substrate, and connecting a metal connection line of a redistribution layer adjacent to the first substrate with a metal connection line of the first substrate, and connecting metal connection lines of two adjacent redistribution layers to each other.

S202, disposing a first die on a top redistribution layer over the first substrate, and connecting the first die with a metal connection line of the top redistribution layer over the surface of the first substrate, so as to obtain a first integrated circuit package structure.

S203, disposing at least two redistribution layers stacked on a second substrate, and connecting a metal connection line of a redistribution layer adjacent to the second substrate with a metal connection line of the second substrate, and connecting metal connection lines of two adjacent redistribution layers to each other.

S204, disposing a second die on a top redistribution layer over the second substrate, and connecting the second die with a metal connection line of the top redistribution layer over the surface of the second substrate, so as to obtain a second integrated circuit package structure.

In this embodiment, the second substrate 1 and the first substrate 1 are the same substrate 1; the redistribution layers on the first substrate 1 and the redistribution layers on the second substrate 1 are different redistribution layers, and/or the second die 3 and the first die 3 are different dies 3.

The second substrate 1 and the first substrate 1 are the same substrate 1, that is, the second substrate 1 and the first substrate 1 are the same type of substrate 1, and respective parts of the first substrate 1 and the second substrate 1 have the same structure and the same circuit function. Specifically, the numbers of metal connection lines of the first substrate 1 and the second substrate 1 are the same, and the metal connection line in each layer thereof have the same function and wiring distribution. The connection position of the first substrate 1 configured to connect with a redistribution layer is the same as the connection position of the second substrate 1 configured to connect with a redistribution layer.

The redistribution layer on the first substrate 1 and the redistribution layer on the second substrate 1 are different redistribution layers, specifically, the number of circuit layers of the redistribution layer on the first substrate 1 is different from the number of circuit layers of the redistribution layer on the second substrate 1, and/or at least part of circuit layers thereof are different.

In this embodiment, at least two redistribution layers 2 are disposed on each of the first substrate 1 and the second substrate 1, and the dies 3 are respectively disposed on the top redistribution layers, wherein the first die 3 and the second die 3 are different dies 3, the redistribution layers on the first substrate 1 and the redistribution layers on the second substrate 1 are different redistribution layers, and the first substrate 1 and the second substrate 1 are the same substrate 1. In this way, reuse of the substrate 1 for different dies 3 can be realized through the at least two redistribution layers 2 between the die 3 and the substrate 1. In addition, the number of layers of the substrate can be reduced and the cost of the electronic package can be saved.

In order to dispose the at least two redistribution layers 2 on a surface of the first substrate 1 more conveniently, in some examples, disposing the at least two redistribution layers 2 stacked on the first substrate 1 may include the following steps:
S201a, disposing a first redistribution assembly on a surface of the first substrate.

In this embodiment, the first redistribution assembly may include a first temporary carrier and a first redistribution layer disposed on and connected to the first temporary carrier.

S201b, connecting a metal connection line of the first redistribution layer with a metal connection line of the first substrate.

S201c, separating the first temporary carrier from the first redistribution layer.

S201d, disposing a second redistribution assembly on the first redistribution layer.

In this embodiment, the second redistribution assembly may include a second temporary carrier and a second redistribution layer disposed on and connected to the second temporary carrier.

S201e, connecting a metal connection line of the second redistribution layer with the metal connection line of the first redistribution layer.

S201f, separating the second temporary carrier from the second redistribution layer.

In order to dispose at least two redistribution layers 2 on the second substrate 1 more conveniently, in some embodiments, disposing at least two redistribution layers 2 stacked on the second substrate 1 may include the following steps:
S203a, disposing a third redistribution assembly on a surface of the second substrate.

In this embodiment, the third redistribution assembly may include a third temporary carrier and a third redistribution layer disposed on and connected to the third temporary carrier.

S203b, connecting a metal connection line of the third redistribution layer with a metal connection line of the second substrate.

S203c, separating the third temporary carrier from the third redistribution layer.

S203d, disposing a fourth redistribution assembly on the third redistribution layer.

In this embodiment, the fourth redistribution assembly may include a fourth temporary carrier and a fourth redistribution layer disposed on and connected to the fourth temporary carrier.

S203e, connecting a metal connection line of the fourth redistribution layer with the metal connection line of the third redistribution layer.

S203f, separating the fourth temporary carrier from the fourth redistribution layer.

In order to improve the manufacturing efficiency of a plurality of redistribution assemblies, in some embodiments, before the disposing the first redistribution assembly on the surface of the first substrate, the integrated circuit packaging method further includes the following process step:

S205, prefabricating redistribution assemblies.

Wherein the prefabricating the redistribution assemblies (S205) may include:
S205a, temporarily connecting two or more temporary carriers to a same one initial carrier.

In some embodiments, the temporarily connecting the two or more temporary carriers to the same one initial carrier (S205a), includes:
D1, temporarily bonding the two or more temporary carriers to the same one initial carrier through a temporary bonding adhesive.
S205b, temporarily generating redistribution layers on the two or more temporary carriers.

In some embodiments, temporarily generating the redistribution layers on the two or more temporary carriers (S205b) may include:
E1, disposing temporary bonding adhesives on the two or more temporary carriers.
E2, generating the redistribution layers on the temporary bonding adhesives.
S205c, separating the two or more temporary carriers from the initial carrier to obtain at least two redistribution assemblies.

In some embodiments, before separating the two or more temporary carriers from the initial carrier, the integrated circuit packaging method may further include:
S206, disposing connection bump(s) on a surface of the temporarily generated redistribution layer away from the temporary carrier; the connection bump(s) is/are connected with the metal connection line of the temporarily generated redistribution layer.

The integrated circuit packaging method in the above embodiment has the same implementation principle and similar technical effect as the integrated circuit packaging method in the foregoing embodiment, and the details can be referred to the foregoing embodiment, which will not be repeated herein.

An embodiment of the present disclosure provides a die performance comparison system, which can reduce the manufacturing cost of the substrate and realize reuse of the substrate.

An embodiment of the present disclosure provides a die performance comparison system, which may include:

A first integrated circuit package structure, the first integrated circuit package structure includes a first substrate, at least two redistribution layers stacked on the first substrate, and a first die disposed on a top redistribution layer; a second integrated circuit package structure, the second integrated circuit package structure includes a second substrate, at least two redistribution layers stacked on the second substrate, and a second die disposed on a top redistribution layer; the second substrate and the first substrate are the same substrate; the redistribution layers on the first substrate and the redistribution layers on the second substrate are different redistribution layers, and/or the second die and the first die are different dies.

A die performance testing device, configured to test the performance of the first die and the second die in the first integrated circuit package structure and the second integrated circuit package structure, respectively, so that a data analysis apparatus can compare the performance of the first die and the second die according to the data obtained from the test.

In the die performance comparison system of this embodiment, at least two redistribution layers are disposed on each of the first substrate and the second substrate, and dies are respectively disposed on the top redistribution layers, wherein the first die and the second die are different dies, the redistribution layers on the first substrate and the redistribution layers on the second substrate are different, and the first substrate and the second substrate are the same substrate. On this basis, the die testing device can perform performance tests for different dies. After the test results are obtained, the data analysis apparatus compares the performance of the first die and the second die according to the data obtained from the test. In this embodiment, in the process of comparing the performance of the first die and the second die, the first substrate and the second substrate are the same substrates, that is, in the process of comparing the performance of the first die and the second die, reuse of the substrate is realized. In addition, the number of layers of the substrate can be reduced, thereby saving the cost of electronic package.

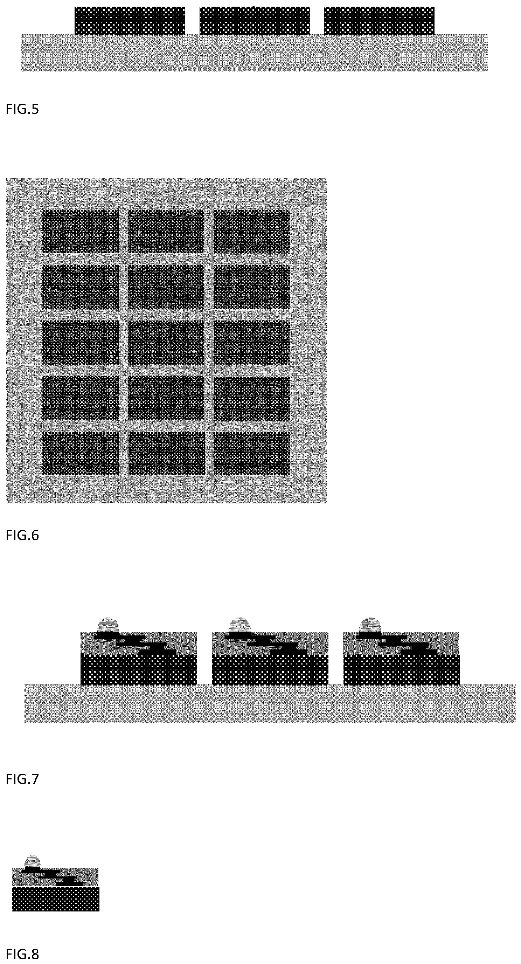

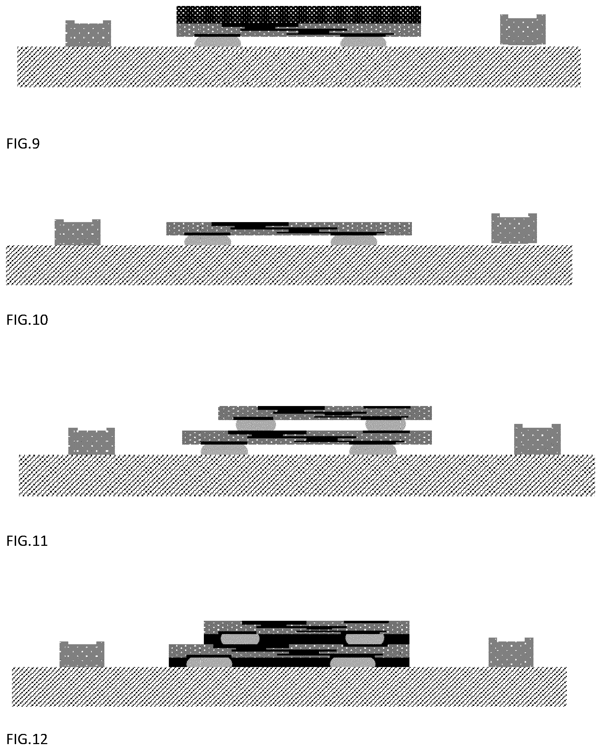

The integrated circuit packaging method of this embodiment may include the following process steps:
1. Referring to FIG. 4 and FIG. 5, redistribution dies with required sizes are temporarily bonded to a surface of a redistribution wafer by a temporary bonding adhesive.
   Referring to FIG. 6, as an alternative embodiment, the redistribution wafer may be replaced by a panel level carrier.
2. disposing temporary bonding adhesives on the redistribution dies disposed on the redistribution wafer, and bonding redistribution layers with required circuit layers on the redistribution dies through the temporary bonding adhesives.
3. Referring to FIG. 7, solder bumps are formed on surfaces of pads of the completed redistribution layers.
4. Referring to FIG. 8, the redistribution dies are de-bonded from the surface of the redistribution wafer to obtain assemblies.
   The assemblies each include a redistribution die, a RDL and a solder bump.
5. Referring to FIG. 9, one of the assemblies is bonded to a surface of a substrate.
   Specifically, the one of the assemblies may be bonded to the surface of the substrate by solder bumps.
6. Referring to FIG. 10, the redistribution die is de-bonded from the RDL.
7. Referring to FIG. 11, on the basis of the RDL formed in step 6, steps 5 and 6 are repeated, so as to stack more RDLs until the required number of RDLs is completed.
8. Referring to FIG. 12, underfill is performed between adjacent RDLs and between RDL and the substrate.
   A underfill dispensing process is performed to form underfill layers between adjacent RDLs among all RDLs and between RDL and the substrate, and a curing process is then performed.
9. Referring to FIG. 1, a required number of functional die(s) is/are bonded to the pad(s) of the RDL.

Referring to FIG. 13, in some examples, while the functional die is bonded to the pad of the RDL, a capacitor may also be bonded to a pad of the RDL.

Thereafter, the subsequent packaging process is completed according to the general process flow.

In this embodiment, the RDL is manufactured first, and then the RDL is attached to the substrate. If one attachment of RDL cannot meet the requirements, the attachment of RDL can be performed for twice or even more times, which greatly increases the number of RDLs in the fan-out package and can obviously reduce the number of substrate layers.

The structure has more layers of RDLs, and the same one substrate and different RDL designs can be used to realize the requirements for some new product research and development, thereby greatly increasing the ability of reusing the substrate for fan-out package.

It should be noted that, herein, relational terms such as first, second or the like are only used to distinguish one object or operation from another object or operation, and do not necessarily require or imply that there is any such actual relationship or order between these objects or operations. Moreover, the terms "comprise", "include" or any other variations thereof are intended to cover non-exclusive inclusion, so that a process, method, article or apparatus including a series of elements includes not only those elements, but also other elements not explicitly listed or elements inherent to such process, method, article or apparatus. Without further restrictions, an element defined by the phrase "comprising one... ", "including one..." does not exclude the existence of other identical elements in the process, method, article or apparatus including the element.

The various embodiments in this disclosure are described in a related way, and the same and similar parts between the various embodiments can be referred to each other, and each embodiment focuses on the differences from other embodiments.

The above is only the specific implementations of this disclosure, but the protection scope of this disclosure is not limited thereto. Any variation or replacement that can be easily thought of by a person familiar with this technical field within the technical scope disclosed in this disclosure should be included in the protection scope of the present disclosure. Therefore, the scope of protection of the present disclosure should be based on the scope of protection of the claims.

## Claims

1. An integrated circuit package structure, comprising:
a substrate;
at least two redistribution layers, wherein the at least two redistribution layers are stacked on the substrate, and a metal connection line of a redistribution layer adjacent to the substrate is connected with a metal connection line of the substrate, and metal connection lines of two adjacent redistribution layers are connected to each other;
a die, wherein the die is disposed on a top redistribution layer, and the die is connected with a metal connection line of the top redistribution layer.

2. The integrated circuit package structure according to claim 1, wherein the at least two redistribution layers comprise a first redistribution layer and a second redistribution layer;
the first redistribution layer is disposed on the substrate, and a metal connection line of the first redistribution layer is connected with the metal connection line of the substrate;
the second redistribution layer is disposed on the first redistribution layer, and a metal connection line of the second redistribution layer is connected with the metal connection line of the first redistribution layer.

3. The integrated circuit package structure according to claim 2, wherein the first redistribution layer is provided with a first connection bump, and the first connection bump is connected with the metal connection line of the first redistribution layer, and the metal connection line of the first redistribution layer is connected with the metal connection line of the substrate through the first connection bump; and/or
the second redistribution layer is provided with a second connection bump, and the second connection bump is connected with the metal connection line of the second redistribution layer, and the metal connection line of the second redistribution layer is connected with the metal connection line of the first redistribution layer through the second connection bump.

4. The integrated circuit package structure according to claim 2, wherein the first redistribution layer is provided with a first connection part, and the first connection part is connected with the metal connection line of the first redistribution layer and bonded to a corresponding connection part of the substrate; the corresponding connection part of the substrate is connected with the metal connection line of the substrate; and/or
the second redistribution layer is provided with a second connection part, the second connection part is connected with the metal connection line of the second redistribution layer, and the second connection part is bonded to a corresponding connection part of the first redistribution layer, and the corresponding connection part of the first redistribution layer is connected with the metal connection line of the first redistribution layer.

5. The integrated circuit package structure according to any one of claims 1-4, further comprising: a capacitor, wherein the capacitor and the die are both disposed on the top redistribution layer; or, the capacitor is disposed on the substrate.

6. An integrated circuit packaging method, comprising:
disposing at least two redistribution layers stacked on a surface of a substrate, and connecting a metal connection line of a redistribution layer adjacent to the substrate with a metal connection line of the substrate, and connecting metal connection lines of two adjacent redistribution layers to each other;
disposing a die on a top redistribution layer, and connecting the die with a metal connection line of the top redistribution layer; or,
disposing a die with a redistribution layer on the top redistribution layer, and connecting a metal lead of the redistribution layer of the die with the metal connection line of the top redistribution layer.

7. The integrated circuit packaging method according to claim 6, wherein the disposing the at least two redistribution layers stacked on the surface of the substrate comprises:
disposing a first redistribution assembly on the surface of the substrate, wherein the first redistribution assembly comprises a first temporary carrier and a first redistribution layer disposed on and connected to the first temporary carrier;
connecting a metal connection line of the first redistribution layer with the metal connection line of the substrate;
separating the first temporary carrier from the first redistribution layer;
disposing a second redistribution assembly on the first redistribution layer, wherein the second redistribution assembly comprises a second temporary carrier and a second redistribution layer disposed on and connected to the second temporary carrier;
connecting a metal connection line of the second redistribution layer with the metal connection line of the first redistribution layer;
separating the second temporary carrier from the second redistribution layer.

8. The integrated circuit packaging method according to claim 7, wherein before the disposing the first redistribution assembly on the surface of the substrate, the integrated circuit packaging method further comprises: prefabricating redistribution assemblies;
wherein the prefabricating the redistribution assemblies comprises:
temporarily connecting two or more temporary carriers to a same one initial carrier;
temporarily generating redistribution layers on the two or more temporary carriers;
separating the two or more temporary carriers from the initial carrier to obtain at least two redistribution assemblies.

9. The integrated circuit packaging method according to claim 8, wherein the temporarily connecting the two or more temporary carriers to the same one initial carrier comprises:
temporarily bonding the two or more temporary carriers to the same one initial carrier through a temporary bonding adhesive.

10. The integrated circuit packaging method according to claim 8 or 9, wherein the temporarily generating the redistribution layers on the two or more temporary carriers comprises:
disposing temporary bonding adhesives on the two or more temporary carriers;
generating the redistribution layers on the temporary bonding adhesives.

11. The integrated circuit packaging method according to any one of claims 8-10, wherein before the separating the two or more temporary carriers from the initial carrier, the integrated circuit packaging method further comprises:
disposing connection bumps on surfaces of the redistribution layers that are temporarily generated away from the temporary carriers, wherein the connection bumps are respectively connected with metal connection lines of the redistribution layers that are temporarily generated.

12. An integrated circuit packaging method, comprising:
disposing at least two redistribution layers stacked on a first substrate, and connecting a metal connection line of a redistribution layer adjacent to the first substrate with a metal connection line of the first substrate, and connecting metal connection lines of two adjacent redistribution layers to each other;
disposing a first die on a top redistribution layer over the first substrate, and connecting the first die with a metal connection line of the top redistribution layer over a surface of the first substrate, so as to obtain a first integrated circuit package structure;
disposing at least two redistribution layers stacked on a second substrate, and connecting a metal connection line of a redistribution layer adjacent to the second substrate with a metal connection line of the second substrate, and connecting metal connection lines of two adjacent redistribution layers to each other;
disposing a second die on a top redistribution layer over the second substrate, and connecting the second die with a metal connection line of the top redistribution layer over a surface of the second substrate, so as to obtain a second integrated circuit package structure;
wherein the second substrate and the first substrate are a same substrate; the redistribution layers on the first substrate and the redistribution layers on the second substrate are different redistribution layers, and/or the second die and the first die are different dies.

13. The integrated circuit packaging method according to claim 12, wherein the disposing the at least two redistribution layers stacked on the first substrate comprises:
disposing a first redistribution assembly on the surface of the first substrate, wherein the first redistribution assembly comprises a first temporary carrier and a first redistribution layer disposed on and connected to the first temporary carrier;
connecting a metal connection line of the first redistribution layer with the metal connection line of the first substrate;
separating the first temporary carrier from the first redistribution layer;
disposing a second redistribution assembly on the first redistribution layer, wherein the second redistribution assembly comprises a second temporary carrier and a second redistribution layer disposed on and connected to the second temporary carrier;
connecting a metal connection line of the second redistribution layer with the metal connection line of the first redistribution layer;
separating the second temporary carrier from the second redistribution layer.

14. The integrated circuit packaging method according to claim 13, wherein the disposing at least two redistribution layers stacked on the second substrate comprises:
disposing a third redistribution assembly on the surface of the second substrate, wherein the third redistribution assembly comprises a third temporary carrier and a third redistribution layer disposed on and connected to the third temporary carrier;
connecting a metal connection line of the third redistribution layer with the metal connection line of the second substrate;
separating the third temporary carrier from the third redistribution layer;
disposing a fourth redistribution assembly on the third redistribution layer, wherein the fourth redistribution assembly comprises a fourth temporary carrier and a fourth redistribution layer disposed on and connected to the fourth temporary carrier;
connecting a metal connection line of the fourth redistribution layer with the metal connection line of the third redistribution layer;
separating the fourth temporary carrier from the fourth redistribution layer.

15. The integrated circuit packaging method according to claim 13 or 14, wherein before the disposing the first redistribution assembly on the surface of the first substrate, the integrated circuit packaging method further comprises: prefabricating redistribution assemblies;
wherein the prefabricating the redistribution assemblies comprises:
temporarily connecting two or more temporary carriers to a same one initial carrier;
temporarily generating redistribution layers on the two or more temporary carriers;
separating the two or more temporary carriers from the initial carrier, so as to obtain at least two redistribution assemblies.

16. The integrated circuit packaging method according to claim 15, wherein the temporarily connecting the two or more temporary carriers to the same one initial carrier comprises:
temporarily bonding the two or more temporary carriers to the same one initial carrier through a temporary bonding adhesive.

17. The integrated circuit packaging method according to claim 15 or 16, wherein the temporarily generating the redistribution layers on the two or more temporary carriers comprises:
disposing temporary bonding adhesives on the two or more temporary carriers;
generating the redistribution layers on the temporary bonding adhesives.

18. The integrated circuit packaging method according to any one of claims 15-17, wherein before the separating the two or more temporary carriers from the initial carrier, the integrated circuit packaging method further comprises:
disposing connection bumps on surfaces of the redistribution layers that are temporarily generated away from the temporary carriers, wherein the connection bumps are respectively connected with metal connection lines of the redistribution layers that are temporarily generated.

19. A die performance comparison system, comprising:
a first integrated circuit package structure, wherein the first integrated circuit package structure comprises a first substrate, at least two redistribution layers stacked on the first substrate, and a first die disposed on a top redistribution layer;
a second integrated circuit package structure, wherein the second integrated circuit package structure comprises a second substrate, at least two redistribution layers stacked on the second substrate, and a second die disposed on a top redistribution layer; wherein the second substrate and the first substrate are a same substrate; the redistribution layers on the first substrate and the redistribution layers on the second substrate are different redistribution layers, and/or the second die and the first die are different dies; and
a die performance testing device, configured to perform a performance test on the first die in the first integrated circuit package structure and the second die in the second integrated circuit package structure, respectively, so that a data analysis apparatus compares performance of the first die and the second die according to data obtained from the performance test.
